# EUROPEAN PATENT SPECIFICATION

(11) **EP 2 852 267 B1**
(45) Date of publication and mention of the grant of the patent: **31.05.2017**
(21) Application number: 13185381.4
(22) Date of filing: 20.09.2013
(51) Int. Cl.: H05K 7/20

(54) **A cooling system for a track-bound vehicle**
Kühlsystem für ein spurgebundenes Fahrzeug
Système de refroidissement pour véhicule guidé sur rails

(43) Date of publication of application: 25.03.2015
(73) Proprietor: Bombardier Transportation GmbH, 10785 Berlin (DE)
(72) Inventor: Skoog, Kjell, 645 40 Strängnäs (SE)
(74) Representative: Olsson, Jan

(56) References cited:
- EP-A1- 1 259 104
- US-A- 4 047 561
- US-A- 5 535 818

## Description

### TECHNICAL FIELD OF THE INVENTION AND BACKGROUND ART

The present invention relates to a cooling system configured to be arranged on board a track-bound vehicle and comprising in a cooling liquid circulating main loop:
- a pump configured to make a cooling liquid to circulate in said loop to cool equipment of said vehicle,
- a heat sink configured to let the cooling liquid absorb heat dissipated in said equipment mounted thereon, and
- a heat exchanger configured to emit heat absorbed from said equipment by said cooling liquid,
the cooling system further comprising
- a by-pass configured to conduct a minor portion of the cooling liquid flow past part of said main loop, and
- an expansion vessel forming part of said by-pass and configured to have an inner volume thereof partly filled by said cooling liquid.

Cooling systems for such vehicles have to be at least substantially closed and may not be connected to any water-supply or cooling liquid-supply system since the vehicle is moving.

The equipment to be cooled may be any, but is especially converters used in such vehicles for the control of electric power transfer.

"Track" is here to be interpreted as a path to be followed by a said vehicle and has not necessarily to be defined by a rail, but may also be defined by an electric power supply line for a wheeled vehicle, such as a bus.

The heat exchanger is in such a cooling system normally cooled by an airflow from a fan, but the invention is not restricted thereto.

The primary purpose of the expansion vessel is to allow the volume of cooling liquid and the volumes of the various parts of the main loop to vary, mainly due to variation in temperature, without resulting in excessive pressure variation.

It is in such a cooling system highly undesirable to have air present in the cooling liquid circulating main loop. One reason is that air entrainment in the pump causes reduction of flow, vibrations, noise and damage to bearings and seals. The air also reduces the cooling capacity of the heat sink and the capacity of the heat exchanger. Oxygen from the air will also increase corrosion within the system.

After initial filling or partial refilling, e.g. after exchange of a part of the system, some air will remain in parts of the system. It will tend to rise to the highest point in the system it can reach, but this a large number of places and cannot all be equipped with valves for bleeding. When the pump is started the air will be dragged on with the circulating cooling liquid, especially in the main loop where the flow velocity is high. To minimize the presence of air in the cooling system, especially in the heat sink and in the heat exchanger where it reduces performance, and also to minimize the contact between the air remaining after filling or refilling, a method or an arrangement for de-airing the cooling system is required. The purpose of the by-pass is to let part of the cooling water, including any air bubbles, leave the high flow velocity main loop and reach the expansion vessel where flow velocity is low and air can separate from liquid by gravity and be collected. The collected air is subsequently discharged from the expansion vessel when filling up with cooling liquid.

However, experience has shown problems with de-airing of such cooling systems, especially after filling thereof with cooling liquid. Turbulences at constrictions, bends and especially in the pump will break up large air bubbles into smaller, eventually forming a kind of foam with the cooling liquid. This makes the de-airing more difficult and time consuming. Insufficient de-airing may then result in unclear level of the liquid in the expansion vessel and false low liquid indications are then common. It has been tried to address these problems by filling the part of the expansion vessel not containing cooling liquid by a metal bellow for ensuring the function to be fulfilled by the expansion vessel while simultaneously preventing existence of air in the system. However, experiences have shown that the problems with de-airing of the system during filling is still there, and air will remain in the liquid after such filling and cause future problems with low liquid indication. These problems are also recurrent as the cooling liquid has to be exchanged at regular intervals to prevent exhaustion of its corrosion inhibitors. Each maintenance workshop therefore needs a separate and costly service unit for filling and de-airing and the associated training of its staff.

Other disadvantages of a cooling system having such a metal bellow in the expansion vessel is that the cost of the expansion vessel will be high and there will be a reserve volume for liquid in the expansion vessel being restricted by the presence of the metal bellow.

The problems mentioned above are adhered to the cooling systems according to the introduction known through EP 1 259 104 A1 for cooling an inverter on board a track-bound vehicle and US 5 535 818 A for cooling an electronic device in general. A liquid cooling system for a power converter having an expansion vessel arranged in a bypass to a main cooling loop is also shown in US4,047,561.

### SUMMARY OF THE INVENTION

The object of the present invention is to provide a cooling system of the type defined in the introduction being improved in at least some aspect with respect to such cooling systems already known.

This object is according to the invention obtained by providing such a cooling system with the features listed in the characterizing part of appended claim 1.

Thus, the present invention is based on the understanding that it is acceptable with some air present in the system as long as it does not stay in the main loop of the cooling system, circulating with the cooling liquid and degrading the performance of the cooling system and the life of its components. This is achieved by arranging a said air-cushion in the expansion vessel to collect and keep the air separate from the main loop cooling liquid flow and also as far as possible separate from the bypass flow, and by arranging the combination of the features of the inlet tube and the porous body in the expansion vessel to form a low flow velocity zone in said by-pass, thereby allowing air bubbles possibly present in the cooling liquid to be separated by gravity and leave the circulation of the cooling liquid and be collected by the air-cushion in the expansion vessel. The porous body also makes it possible for liquid leaving the inlet tube through said apertures above the surface of the cooling liquid in the expansion vessel to softly reach said surface while pouring down via the porous body to avoid splashing that would create new bubbles. By taking the return flow to the main loop from the bottom of the expansion vessel the return of air bubbles is minimized.

This design of the expansion vessel makes it possible to increase the acceptable variation of the volume of cooling liquid contained therein substantially compared to an expansion vessel of the same external size having a said metal bellow, which will eliminate low water (cooling liquid) indications due to not completely and incorrect filled system. Furthermore, the rapid and automatic de-airing of the cooling liquid taking place in the expansion vessel means that said separate and costly service unit necessary for filling and de-airing the system as well as experienced staff needed for service of the system will be superfluous.

According to an embodiment of the invention said rising portion of the inlet tube extends to the region of a top of said inner volume of the expansion vessel.

According to another embodiment of the invention said porous body is made of elements providing it with a large total surface exceeding the surface of the external limitation of the porous body by more than 200%, more than 400% or more than 1 000%. Such a large surface of the porous body promotes merging of small bubbles of air possibly present in the liquid to larger bubbles which may more easily be separated by gravity to the air-cushion in said inner volume of the expansion vessel.

According to other embodiments of the invention said porous body comprises a filter mat and the filter mat may be formed by a wire netting.

According to another embodiment of the invention said expansion vessel has a first valve connected between an upper portion of said inner volume to be filled by air and the exterior and a spring means configured to keep said first valve closed for an air pressure in said air-cushion below a first predetermined value and to open the valve and let air out of said expansion vessel for an air pressure in said air-cushion above said first predetermined value. The arrangement of such a valve automatically limits the highest system pressure to said first predetermined value. This first predetermined value is according to another embodiment of the invention an over-pressure of 0.1 - 0.6, 0.2 - 0.5 or 0.3 - 0.4 bar with respect to the exterior. It is a particular advantage if the over-pressure is limited to a value making it unnecessary for the expansion vessel to comply with pressure vessel legislation. The size of the expansion vessel is preferably chosen so that this over pressure valve does not have to operate for expected temperature variation of the cooling system.

According to another embodiment of the invention said expansion vessel has a second valve connected between an upper portion of said inner volume to be filled by air and the exterior and a spring means configured to keep said second valve closed for an air pressure in said air-cushion above a second predetermined value and to open the valve and let air into said expansion vessel for an air pressure in said air-cushion below a said second predetermined value. Such a second valve automatically limits the lowest system pressure to said second predetermined value, which according to another embodiment of the invention is a negative pressure of 0.05 - 0.4, 0.1 - 0.3 or 0.1 - 0.2 bar with respect to the exterior, thereby preventing collapse of connection hoses on the suction side of the pump and cavitation in the pump. The size of the expansion vessel is preferably chosen so that this under pressure valve does not have to operate for expected temperature variation of the cooling system.

Said spring means configured to keep said valves closed are preferably compression springs, and said predetermined values may be changed by changing said springs.

According to another embodiment of the invention said first and second valves are connected via one and the same tube to the inner volume to be filled by air in the upper portion of the expansion vessel.

According to another embodiment of the invention the output side of said pump is connected to said heat exchanger, and said by-pass is connected from the output side of the heat exchanger to the input side of the pump. Another possibility is to have the output side of the pump connected to the heat sink and the by-pass and the by-pass connected from the output side of the heat sink to the input side of the pump. The connection of the by-pass chosen is dependent upon where the highest part of the system is located, since that is the place where most air tends to be present. "The output side of the heat sink" may in fact be the input side of the heat exchanger.

According to another embodiment of the invention said inlet tube has at least one hole through a wall thereof near the bottom of the expansion vessel and on the inside of the expansion vessel. Such a hole will prevent that air is sucked into the inlet tube and rise into the cooling liquid in the main loop when the pump is stopped.

According to another embodiment of the invention the cooling system comprises an arrangement configured to indicate the surface level of liquid inside said expansion vessel and comprising a tube having a lower end connected to the inner volume of the expansion vessel below the lowest acceptable cooling liquid level and the other end connected to the upper part of the expansion vessel and having an indicating float indicating said surface level. This arrangement may then comprise an inductive sensor arranged close to said rising tube and said indicating float is of a metallic material to be sensed by said inductive sensor. Such a surface level indicating arrangement is favourable for checking that the cooling liquid has an appropriate level in the expansion vessel during filling and also during operation of the cooling system.

Said inductive sensor is then according to another embodiment of the invention arranged at the level being a lowest acceptable level of said cooling liquid in the expansion vessel and to create a warning signal when this level is reached by a surface of the cooling liquid inside the expansion vessel. The inductive sensor may then ensure that the operation of the equipment cooled by said cooling liquid may be stopped before there is a risk of improper function of the cooling system due to air from the expansion vessel returning into the cooling liquid main loop of the system.

The invention also relates to a track-bound vehicle as well as a use of a cooling system according to the appended claims therefor.

Further advantages as well as advantageous features of the invention will appear from the following description of embodiments of the invention.

### BRIEF DESCRIPTION OF THE DRAWINGS

With reference to appended drawings, below follows a specific description of embodiments of the invention cited as examples.

In the drawings:
- Fig 1: is a simplified schematic view of a cooling system according to an embodiment of the invention,
- Figs 2 and 3: are perspective views of a part of the cooling system shown in Fig 1,
- Fig 4: is a simplified schematic view of the expansion vessel and associated equipment of the cooling system shown in Fig 1,
- Fig 5: is a perspective view of said expansion vessel, and
- Fig 6: is a view corresponding to Fig 1 of a cooling system according to another embodiment of the invention.

### DETAILED DESCRIPTION OF EMBODIMENTS OF THE INVENTION

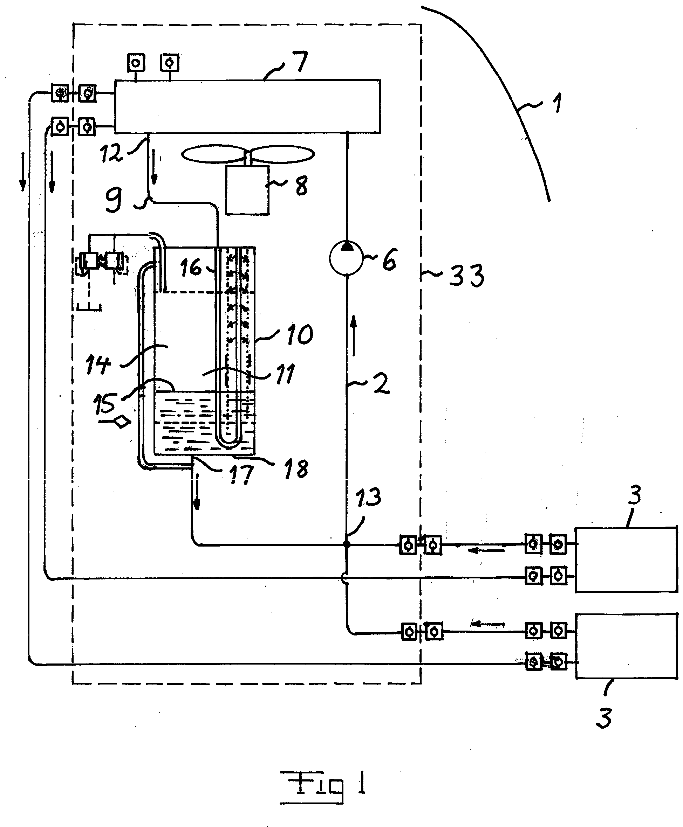

Fig 1 shows schematically the main parts of a cooling system according to the invention configured to be arranged on board a track-bound vehicle 1. The cooling system has a main loop 2 in which a cooling liquid is intended to circulate for cooling equipment arranged in the vehicle, in this case converters for the control of electric power transfer from an AC- or DC-supply line to one or several motors and other equipment of the vehicle or in the opposite direction when the vehicle is braking. The main loop does for this have at least one heat sink 3, here two, upon which for example power semiconductor modules are arranged and through which the cooling liquid will circulate for absorbing heat dissipated by the power semiconductor modules. The power semiconductor modules may be part of power electronic converters. The main loop has also a pump 6 configured to make the cooling liquid to circulate in the loop as well as a heat exchanger 7 configured to emit heat absorbed by the cooling liquid in the heat sinks 3. The emission of heat in the heat exchanger for lowering the temperature of the cooling liquid is increased by a fan 8 creating an airflow passing the heat exchanger.

The cooling system also comprises a by-pass 9 configured to conduct a minor portion, for example 5%, of the cooling liquid flow past part of the main loop and an expansion vessel 10 forming part of the by-pass 9 and configured to have an inner volume 11 thereof partly filled by the cooling liquid. The by-pass is here connected from the output side 12 of the heat exchanger 7 to the input side 13 of the pump 6. The expansion vessel 10 is configured to have an air-cushion 14 in the inner volume thereof above the surface 15 of the cooling liquid therein. The expansion vessel has an inlet tube 16 connected to the highest part of either the heat sink 3 or the heat exchanger, which accordingly here is the highest part of the heat exchanger, and extending inside the expansion vessel 10.

The expansion vessel has also an outlet 17 from the bottom 18 of the expansion vessel, which is connected to a point of the main loop, here said input side 13 of the pump 6, configured to have a lower pressure than said highest part of either said heat sink our said heat exchanger, here the heat exchanger, to which the inlet tube is connected. This is for obtaining a pressure difference driving the flow of cooling liquid in said by-pass through the expansion vessel.

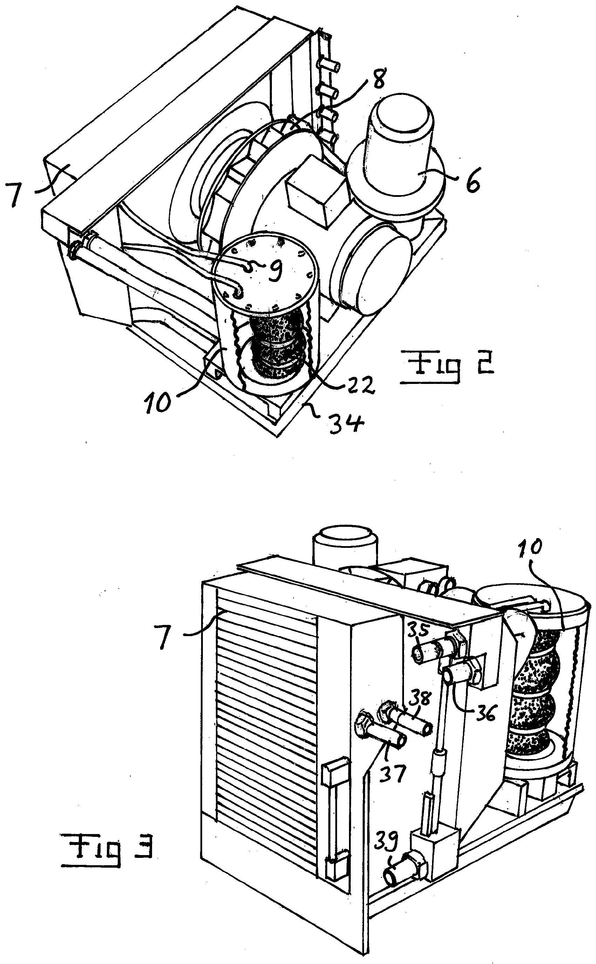

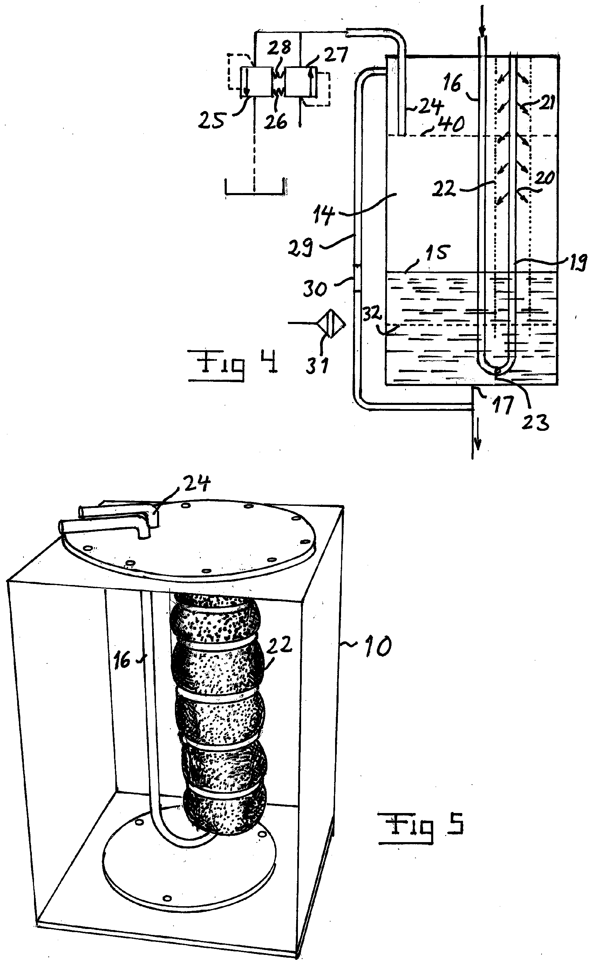

Reference is now also made to Figs 2-5, especially Figs 4 and 5. The inlet tube 16 passes via the lower part of the expansion vessel and has thereafter a rising portion 19 with apertures 20 in a wall of the tube for letting cooling liquid out of the tube in this rising portion and into the inner volume 11 of the expansion vessel as indicated by the arrows 21 in Fig 4. At least some of the apertures 20 are located in a part of the inner volume configured to be filled by air of said air-cushion 14. The expansion vessel 10 also contains a porous body 22 surrounding said rising tube portion 19 where the apertures are located and even below thereof, at least down to the lowest acceptable level of the cooling liquid. The function of this porous body 22 is primarily to reduce and homogenize the flow velocity of the cooling liquid. The reduced flow velocity enhances the separation of the air bubbles and prevents splashing that could create new air bubbles. The porous body 22 is preferably made of elements providing it with a large total surface exceeding the surface of the external limitation of the porous body by more than 200%, more than 400% or more than 1 000% by comprising a filter mat formed by a wire netting. The function of this filter mat is actually not a filtering function, but a material intended for filtering is in principle suitable as such a porous body. When the cooling liquid flowing through the apertures 20 into the porous body 22 carries small bubbles of air these will "meet" each other and merge more easily in such a wire netting 22. This may also be described as: Small bubbles of air and dissolved gas in the cooling liquid pass through the wire netting 22 that facilitates nucleation, clustering and growth of bubbles.

The increase of the bubble size enhances the separation of the air by gravity. The cooling liquid is pouring down via the wire netting 22 to avoid splashing that would create new bubbles. Accordingly, the cooling system is automatically de-aired into the air-cushion 14 in the expansion vessel.

Furthermore, the inlet tube 16 has at least one hole 23 through a wall thereof near the bottom of the expansion vessel and on the inside of the expansion vessel for avoiding that when the pump is stopped and the system cools down air will be sucked from the air-cushion 14 through the apertures 20 and eventually rise from the expansion vessel into the heat exchanger. This may otherwise happen, since the air cushion in the vessel is not the highest point. The hole 23 is preferably remote from the outlet 17.

The level of said surface 15 of cooling liquid inside the expansion vessel will in this system with a constant amount of cooling liquid vary with the volume of this liquid and by that with the temperature thereof and also with the total volume of the parts of the cooling system which also varies with the temperatures of these parts. The system does for this purpose comprise means for regulating the air pressure of said air-cushion. The inner volume to be filled by air, i.e. said air-cushion 14, in the upper portion of the expansion vessel is connected through a tube 24 to a first valve 25 influenced by a spring means 26 configured to keep this first valve closed for an air pressure in said air-cushion below a first predetermined value being an over pressure with respect to the exterior, such as in the order of 0.1 - 0.6 bar, and to open the valve and let air out of the expansion vessel for an air pressure above this first predetermined value. A second valve 27 is also connected to the air-cushion 14 in the upper portion of the expansion vessel and is arranged to be influenced by a spring means 28 configured to keep this second valve closed for an air pressure in said air-cushion above a second predetermined value, such as a negative pressure of 0.05 - 0.4 bar with respect to the exterior, and let air into the expansion vessel for an air pressure in said air-cushion below this second predetermined value. The two spring means are preferably compression springs. The presence of these valves constitute a protection of the expansion vessel with respect to over pressure and low pressure, respectively.

During filling of the cooling system with cooling liquid de-airing of the system will take place through the first valve 25, through which also cooling liquid may be drained when the level thereof inside the expansion vessel reaches the highest level 40 for avoiding overfilling.

The system also has an arrangement configured to indicate the surface level of liquid inside the expansion vessel, and this comprises an essentially vertical tube 29 external to the expansion vessel and connected by one end to the bottom of the expansion vessel and by the other end to the top of the expansion vessel and having an indicating float 30 indicating the surface level. Said arrangement has also an inductive sensor 31 arranged close to the vertical tube 29, and the indicating float 30 is of a metallic material to be sensed by the inductive sensor. The inductive sensor 31 is arranged at a level 32 being a lowest acceptable level of the cooling liquid in the expansion vessel and to create a warning signal when this level is reached by the surface 15.

It is shown in Fig 2 and 3 how the parts of the cooling system within a dashed box 33 in Fig 1 may be compactly arranged on a same frame 34, which may be arranged inside said vehicle or on the roof thereof then covered by a suitable casing. The inlets from the modules to the pump are indicated by 35 and 36, the outlets from the heat exchanger to the heat sink 3 by 37 and 38 and a filling and draining connection by 39.

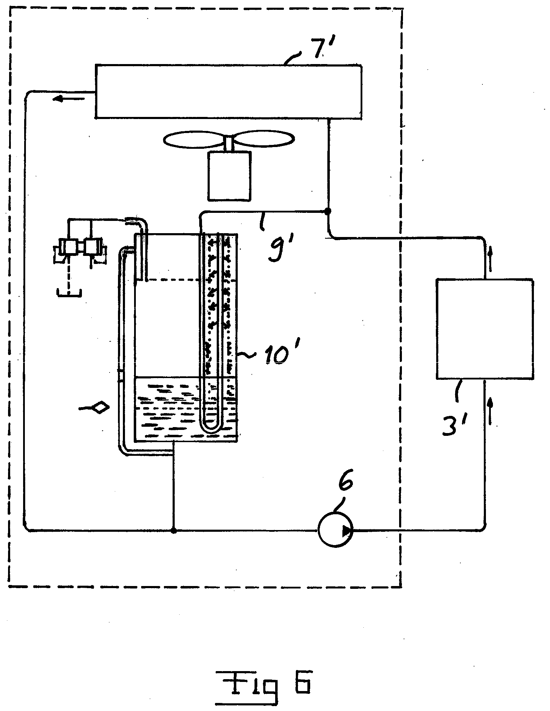

Fig 6 illustrates very schematically a second possible embodiment of the cooling system according to the invention, which differs from that shown in Fig 1 by the fact that the outlet of the pump 6 is here connected to the heat sink 3' and the by-pass 9' is connected between the input to the heat exchanger 7' and the input to the pump. The expansion vessel 10' and parts contained therein or connected thereto may be the same as in the embodiment shown in Fig 1.

The invention is of course not in any way restricted to embodiments described above, but many possibilities to modifications thereof would be apparent to a person with skill in the art without departing from the scope of the invention as defined in the appended claims.

## Claims

1. A cooling system configured to be arranged on board a track-bound vehicle and comprising in a cooling liquid circulating main loop (2):
• a pump (6) configured to make a cooling liquid to circulate in said loop to cool equipment of said vehicle,
• a heat sink (3, 3') configured to let the cooling liquid absorb heat dissipated in said equipment mounted thereon, and
• a heat exchanger (7, 7') configured to emit heat absorbed from said equipment by said cooling liquid,
the cooling system further comprising
• a by-pass (9) configured to conduct a minor portion of the cooling liquid flow past part of said main loop (2), and
• an expansion vessel (10, 10') forming part of said by-pass and configured to have an inner volume (11) thereof partly filled by said cooling liquid,
**characterized in that** the expansion vessel (10, 10') is configured to have an air-cushion (14) in the inner volume thereof above a surface (15) of said cooling liquid therein, that the expansion vessel has an inlet tube (16) connected to the highest part of either said heat sink (3, 3') or said heat exchanger (7, 7') and extending inside said vessel,
that the expansion vessel has an outlet (17) from the bottom (18) of said vessel and connected to a point of said main loop configured to have a lower pressure than said highest part of either said heat sink or said heat exchanger to which the inlet tube (16) is connected,
that said inlet tube passes via the lower part of said vessel and has thereafter a rising portion (19) with apertures (20) in a wall of the tube for letting cooling liquid out of the tube in said rising portion and into said inner volume, at least some of said apertures being located in a part of said inner volume configured to be filled by air of said air-cushion (14),
and that the expansion vessel contains a porous body (22) surrounding said rising tube portion (19) where said apertures (20) are located.

2. A cooling system according to claim 1, **characterized in that** said rising portion (19) of the inlet tube (16) extends to the region of a top of said inner volume (11) of the expansion vessel (10, 10').

3. A cooling system according to claim 1 or 2, **characterized in that** said porous body (22) is made of elements providing it with a large total surface exceeding the surface of the external limitation of the porous body by more than 200 %, more than 400 % or more than 1 000 %.

4. A cooling system according to any of the preceding claims, **characterized in that** said porous body (22) comprises a filter mat.

5. A cooling system according to claim 4, **characterized in that** said filter mat is formed by a wire netting.

6. A cooling system according to any of the preceding claims, **characterized in that** said expansion vessel (10, 10') has a first valve (25) connected between an upper portion of said inner volume to be filled by air and the exterior and a spring means (26) configured to keep said first valve closed for an air pressure in said air-cushion below a first predetermined value and to open the valve and let air out of said expansion vessel for an air pressure in said air-cushion (14) above said first predetermined value.

7. A cooling system according to claim 6, **characterized in that** said first predetermined value is an overpressure of 0.1-0.6, 0.2 - 0.5 or 0.3-0.4 bar with respect to the exterior.

8. A cooling system according to any of the preceding claims, **characterized in that** said expansion vessel (10, 10') has a second valve (27) connected between an upper portion of said inner volume to be filled by air and the exterior and a spring means (28) configured to keep said second valve closed for an air pressure in said air-cushion above a second predetermined value and to open the valve and let air into said expansion vessel for an air pressure in said air-cushion (14) below a said second predetermined value.

9. A cooling system according to claim 8, **characterized in that** said second predetermined value is a negative pressure of 0.05-0.4, 0.1-0.3 or 0.1-0.2 bar with respect to the exterior.

10. A cooling system according to claim 6 or 8, **characterized in that** said spring means (26, 28) comprises a compression spring.

11. A cooling system according to at least claims 6 and 8, **characterized in that** said first and second valves are connected via one and the same tube (24) to the inner volume to be filled by air in the upper portion of the expansion vessel (10, 10').

12. A cooling system according to any of the preceding claims, **characterized in that** the output side of said pump (6) is connected to the said heat exchanger (7), and that said by-pass (9) is connected from the output side (12) of the heat exchanger to the input side (13) of the pump.

13. A cooling system according to any of claims 1-11, **characterized in that** the output side of said pump (6) is connected to said heat sink (3'), and that said by-pass (9') is connected from the output side of said heat sink to the input side of the pump.

14. A cooling system according to any of the preceding claims, **characterized in that** said inlet tube (19) has at least one hole (23) through a wall thereof near the bottom of the expansion vessel (10, 10') and on the inside of the expansion vessel.

15. A cooling system according to any of the preceding claims, **characterized in that** it comprises an arrangement configured to indicate the surface level of liquid inside said expansion vessel (10, 10') and comprising a tube (29) having a lower end connected to the inner volume of the expansion vessel below the lowest acceptable cooling liquid level and the other end connected to the upper part of the expansion vessel and having an indicating float (30) indicating said surface level.

16. A cooling system according to claim 15, **characterized in that** said arrangement comprises an inductive sensor (31) arranged close to said rising tube (29) and said indicating float (30) is of a metallic material to be sensed by said inductive sensor.

17. A cooling system according to claim 16, **characterized in that** said inductive sensor (31) is arranged at a level being a lowest acceptable level (32) of said cooling liquid in the expansion vessel (10, 10') and to create a warning signal when this level is reached by a surface of the cooling liquid inside the expansion vessel.

18. A track-bound vehicle, **characterized in that** it is provided with a cooling system according to any of claims 1-17.

19. Use of a cooling system according to any of claims 1-17 for cooling converters for the control of electric power transfer in a track-bound vehicle.

## Patentansprüche

1. Ein Kühlsystem, das dazu konfiguriert ist an Bord eines spurgebundenen Fahrzeugs angeordnet zu werden, und das in einem Kühlflüssigkeit zirkulierenden Hauptkreislauf (2) umfasst:
- eine Pumpe (6), die dazu konfiguriert ist, eine Kühlflüssigkeit in dem Kreislauf zirkulieren zu lassen, um Ausrüstung des Fahrzeugs zu kühlen,
- eine Wärmesenke (3, 3') die dazu konfiguriert ist, die Kühlflüssigkeit Wärme aufnehmen zu lassen, welche von der daran angeschlossenen Ausrüstung abgegeben wird, und
- einen Wärmetauscher (7, 7 '), der dazu konfiguriert ist, die durch die Kühlflüssigkeit von der Ausrüstung aufgenommene Wärme abzugeben,
wobei das Kühlsystem ferner umfasst
- einen Bypass (9), der dazu konfiguriert ist, einen kleineren Teil des Kühlflüssigkeitsstroms an einem Teil des Hauptkreislaufs (2) vorbeizuführen, und
- ein Ausdehnungsgefäß (10, 10'), das einen Teil des Bypass bildet und dazu konfiguriert ist, ein Innenvolumen (11) aufzuweisen, das teilweise mit der Kühlflüssigkeit gefüllt ist,
**dadurch gekennzeichnet, dass** das Ausdehnungsgefäß (10, 10') dazu konfiguriert ist, ein Luftkissen (14) in seinem Innenvolumen oberhalb einer Oberfläche (15) der darin befindlichen Kühlflüssigkeit aufzuweisen, dass das Ausdehnungsgefäß ein Einlassrohr (16) aufweist, das mit dem höchsten Teil entweder der Wärmesenke (3, 3') oder des Wärmetauschers (7, 7') verbunden ist und sich innerhalb des Gefäßes erstreckt,
dass das Ausdehnungsgefäß einen Auslass (17) aufweist, der von dem Boden (18) des Gefäßes ausgeht und mit einem Punkt des Hauptkreislaufes verbunden ist, der dazu konfiguriert ist, einen niedrigeren Druck aufzuweisen als der höchste Teil entweder der Wärmesenke oder des Wärmetauschers, mit dem das Einlassrohr (16) verbunden ist,
dass das Einlassrohr über den unteren Teil des Gefäßes verläuft und danach einen ansteigenden Abschnitt (19) mit Öffnungen (20) in einer Wand des Rohrs aufweist, um in dem ansteigenden Abschnitt Kühlflüssigkeit aus dem Rohr und in das Innenvolumen auszulassen, wobei sich zumindest einige der Öffnungen in einem Teil des Innenvolumens befinden, der dazu konfiguriert ist, mit Luft des Luftkissens (14) gefüllt zu sein,
und dass das Ausdehnungsgefäß einen porösen Körper (22) enthält, der den ansteigenden Rohrabschnitt (19) umgibt, in dem die Öffnungen (20) angeordnet sind.

2. Ein Kühlsystem nach Anspruch 1, **dadurch gekennzeichnet, dass** der ansteigende Abschnitt (19) des Einlassrohrs (16) sich bis zum Bereich einer Oberseite des Innenvolumens (11) des Ausdehnungsgefäßes (10, 10') erstreckt.

3. Ein Kühlsystem nach Anspruch 1 oder 2, dass der poröse Körper (22) aus Elementen gebildet ist, die ihn mit einer großen Gesamtoberfläche versehen, welche die Oberfläche der äußeren Begrenzung des porösen Körpers um mehr als 200%, mehr als 400% oder mehr als 1000% übersteigt.

4. Ein Kühlsystem nach einem der vorhergehenden Ansprüche **dadurch gekennzeichnet, dass** der poröse Körper (22) eine Filtermatte umfasst.

5. Ein Kühlsystem nach Anspruch 4, **dadurch gekennzeichnet, dass** die Filtermatte durch ein Drahtnetz ausgebildet ist.

6. Ein Kühlsystem nach einem der vorhergehenden Ansprüche, **dadurch gekennzeichnet, dass** das Ausdehnungsgefäß (10, 10 ') ein erstes Ventil (25) aufweist, das mit einem oberen Abschnitt des Innenvolumens, der mit Luft zu füllen ist, und der Umgebung verbunden ist, und ein Federmittel (26) aufweist, das dazu konfiguriert ist, das erste Ventil bei einen Luftdruck in dem Luftkissen geschlossen zu halten, der unter einem ersten vorbestimmten Wert liegt, und das Ventil zu öffnen und Luft aus dem Ausdehnungsgefäß bei einen Luftdruck in dem Luftkissen (14) auszulassen, der oberhalb des ersten vorbestimmten Wertes liegt.

7. Ein Kühlsystem nach Anspruch 6, **dadurch gekennzeichnet, dass** der erste vorbestimmte Wert ein Überdruck von 0.1 - 0.6, 0.2 - 0.5 oder 0.3 - 0.4 bar gegenüber der Umgebung ist.

8. Ein Kühlsystem nach einem der vorhergehenden Ansprüche, **dadurch gekennzeichnet, dass** das Ausdehnungsgefäß (10, 10 ') ein zweites Ventil (27) aufweist, das zwischen einem oberen Abschnitt des Innenvolumens, der mit Luft zu füllen ist, und der Umgebung verbunden ist, und ein Federmittel (28) aufweist, das dazu konfiguriert ist, das zweite Ventil bei einem Luftdruck in dem Luftkissen geschlossen zu halten, der über einem zweiten vorbestimmten Wert liegt, und das Ventil zu öffnen und Luft in das Ausdehnungsgefäß bei einem Luftdruck in dem Luftkissen (14) einzulassen, der unter dem zweiten vorbestimmte Wert liegt.

9. Ein Kühlsystem nach Anspruch 8, **dadurch gekennzeichnet, dass** der zweite vorbestimmte Wert ein Unterdruck von 0,05 - 0,4, 0,1 - 0,3 oder 0,1 - 0,2 bar gegenüber der Umgebung ist.

10. Ein Kühlsystem nach Anspruch 6 oder 8, **dadurch gekennzeichnet, dass** die Federmittel (26, 28) eine Druckfeder umfassen.

11. Ein Kühlsystem nach zumindest Anspruch 6 und 8, **dadurch gekennzeichnet, dass** die ersten und zweiten Ventile über ein und dasselbe Rohr (24) mit dem Innenvolumen verbunden sind, das in dem oberen Teil des Ausdehnungsgefäßes (10, 10 ') mit Luft zu befüllen ist.

12. Ein Kühlsystem nach einem der vorhergehenden Ansprüche, **dadurch gekennzeichnet, dass** die Ausgangsseite der Pumpe (6) mit dem Wärmetauscher (7) verbunden ist, und dass der Bypass (9) von der Ausgangsseite (12) des Wärmetauschers zu der Eingangsseite (13) der Pumpe angeschlossen ist.

13. Ein Kühlsystem nach einem der Ansprüche 1 - 11, **dadurch gekennzeichnet, dass** die Ausgangsseite der Pumpe (6) mit der Wärmesenke (3') verbunden ist und dass der Bypass (9') von der Ausgangsseite der Wärmesenke zu der Eingangsseite der Pumpe angeschlossen ist.

14. Ein Kühlsystem nach einem der vorhergehenden Ansprüche, **dadurch gekennzeichnet, dass** das Einlassrohr (19) mindestens ein Loch (23) durch eine Wand davon nahe dem Boden des Ausdehnungsgefäßes (10, 10') und auf der Innenseite der Ausdehnungsgefäßes aufweist.

15. Ein Kühlsystem nach einem der vorhergehenden Ansprüche, **dadurch gekennzeichnet, dass** es eine Anordnung aufweist, die dazu konfiguriert ist, das Oberflächenniveau von Flüssigkeit im Inneren des Ausdehnungsgefäßes (10, 10') anzuzeigen, und ein Rohr (29) umfasst, das ein unteres Ende aufweist, das mit dem Innenvolumen des Ausdehnungsgefäßes unterhalb des niedrigsten akzeptablen Kühlflüssigkeitsniveaus verbunden ist, und dessen anderes Ende mit dem oberen Teil des Ausdehnungsgefäßes verbunden ist und einen Anzeige-Schwimmer (30) aufweist, der das Oberflächenniveau anzeigt.

16. Ein Kühlsystem nach Anspruch 15, **dadurch gekennzeichnet, dass** die Anordnung einen induktiver Sensor (31) umfasst, der in der Nähe der ansteigenden Röhre (29) angeordnet ist, und der Anzeige-Schwimmer (30) aus einem metallischen Material ausgebildet ist, das durch den induktiven Sensor erfassbar ist.

17. Ein Kühlsystem nach Anspruch 16, **dadurch gekennzeichnet, dass** der induktive Sensor (31) auf einem Niveau angeordnet ist, das einem niedrigsten akzeptablen Niveau (32) der Kühlflüssigkeit in dem Ausdehnungsgefäß (10, 10') entspricht, und dazu ausgebildet ist, ein Warnsignal zu erzeugen, wenn dieses Niveau durch eine Oberfläche der Kühlflüssigkeit im Inneren des Ausdehnungsgefäßes erreicht wird.

18. Ein schienengebundenes Fahrzeug, **dadurch gekennzeichnet, dass** es ein Kühlsystem gemäß einem der Ansprüche 1 - 17 aufweist.

19. Verwendung eines Kühlsystems nach einem der Ansprüche 1 - 17 zur Kühlung der Umrichter für die Steuerung der elektrischen Energieübertragung in einem spurgebundenen Fahrzeug.

## Revendications

1. Système de refroidissement configuré pour être agencé à bord d'un véhicule guidé sur rails et comprenant, dans une boucle principale de circulation de liquide de refroidissement (2) :
• une pompe (6) configurée pour faire circuler un liquide de refroidissement dans ladite boucle afin de refroidir l'équipement dudit véhicule,
• un dissipateur de chaleur (3, 3') configuré pour laisser le liquide de refroidissement absorber de la chaleur dissipée dans ledit équipement monté dessus, et
• un échangeur de chaleur (7, 7') configuré pour émettre de la chaleur absorbée à partir dudit équipement par ledit liquide de refroidissement,
le système de refroidissement comprenant en outre
• une dérivation (9) configurée pour amener une portion mineure du liquide de refroidissement à s'écouler le long d'une partie de ladite boucle principale (2), et
• un vase d'expansion (10, 10') faisant partie de ladite dérivation et configuré pour avoir un volume interne (11) de celui-ci en partie rempli par ledit liquide de refroidissement,
**caractérisé en ce que** le vase d'expansion (10, 10') est configuré pour avoir un coussin d'air (14) dans le volume interne de celui-ci au-dessus d'une surface (15) dudit liquide de refroidissement en son sein,
**en ce que** le vase d'expansion comporte un tube d'admission (16) raccordé à la partie la plus haute soit dudit dissipateur de chaleur (3, 3'), soit dudit échangeur de chaleur (7, 7') et s'étendant à l'intérieur dudit vase,
**en ce que** le vase d'expansion comporte un refoulement (17) à partir du fond (18) dudit vase et raccordé à un point de ladite boucle principale configuré pour avoir une pression inférieure à ladite partie la plus haute soit dudit dissipateur de chaleur, soit dudit échangeur de chaleur auquel le tube d'admission (16) est raccordé,
**en ce que** ledit tube d'admission passe par la partie inférieure dudit vase et comporte ensuite une portion ascendante (19) avec des ouvertures (20) dans une paroi du tube pour laisser le liquide de refroidissement sortir du tube dans ladite portion ascendante et dans ledit volume interne, au moins certaines des ouvertures étant situées dans une partie dudit volume interne configurée pour être remplie d'air dudit coussin d'air (14),
et **en ce que** le vase d'expansion contient un corps poreux (22) entourant ladite portion de tube ascendante (19) où sont situées lesdites ouvertures (20).

2. Système de refroidissement selon la revendication 1, **caractérisé en ce que** ladite portion ascendante (19) du tube d'admission (16) s'étend vers la région d'un sommet dudit volume interne (11) du vase d'expansion (10, 10').

3. Système de refroidissement selon la revendication 1 ou 2, **caractérisé en ce que** ledit corps poreux (22) est fait d'éléments le dotant d'une grande surface totale excédant la surface de la limitation externe du corps poreux de plus de 200 %, de plus de 400 % ou de plus de 1 000 %.

4. Système de refroidissement selon l'une quelconque des revendications précédentes, **caractérisé en ce que** ledit corps poreux (22) comprend une nappe filtrante.

5. Système de refroidissement selon la revendication 4, **caractérisé en ce que** la nappe filtrante est formée d'un treillis métallique.

6. Système de refroidissement selon l'une quelconque des revendications précédentes, **caractérisé en ce que** ledit vase d'expansion (10, 10') comporte une première vanne (25) raccordée entre une portion supérieure dudit volume interne à remplir d'air et l'extérieur et un moyen de ressort (26) configuré pour maintenir ladite première vanne fermée pour une pression d'air dans ledit coussin d'air en dessous d'une première valeur prédéterminée et pour ouvrir la vanne et laisser l'air sortir dudit vase d'expansion pour une pression d'air dans ledit coussin d'air (14) au-dessus de ladite première valeur prédéterminée.

7. Système de refroidissement selon la revendication 6, **caractérisé en ce que** ladite première valeur prédéterminée est une surpression de 0,1 à 0,6, 0,2 à 0,5 ou 0,3 à 0,4 bar par rapport à l'extérieur.

8. Système de refroidissement selon l'une quelconque des revendications précédentes, **caractérisé en ce que** ledit vase d'expansion (10, 10') comporte une seconde vanne (27) raccordée entre une portion supérieure dudit volume interne à remplir d'air et l'extérieur et un moyen de ressort (28) configuré pour maintenir ladite seconde vanne fermée pour une pression d'air dans ledit coussin d'air au-dessus d'une seconde valeur prédéterminée et pour ouvrir la vanne et laisser l'air entrer dans ledit vase d'expansion pour une pression d'air dans ledit coussin d'air (14) en dessous de ladite seconde valeur prédéterminée.

9. Système de refroidissement selon la revendication 8, **caractérisé en ce que** ladite seconde valeur prédéterminée est une pression négative de 0,05 à 0,4, 0,1 à 0,3 ou 0,1 à 0,2 bar par rapport à l'extérieur.

10. Système de refroidissement selon la revendication 6 ou 8, **caractérisé en ce que** ledit moyen de ressort (26, 28) comprend un ressort de compression.

11. Système de refroidissement selon au moins les revendications 6 et 8, **caractérisé en ce que** lesdites première et seconde vannes sont raccordées par l'intermédiaire d'un seul et même tube (24) au volume interne à remplir d'air dans la portion supérieure du vase d'expansion (10, 10').

12. Système de refroidissement selon l'une quelconque des revendications précédentes, **caractérisé en ce que** le côté sortie de ladite pompe (6) est raccordé audit échangeur de chaleur (7), et **en ce que** ladite dérivation (9) est raccordée à partir du côté sortie (12) de l'échangeur de chaleur jusqu'au côté entrée (13) de la pompe.

13. Système de refroidissement selon l'une quelconque des revendications précédentes 1 à 11, **caractérisé en ce que** le côté sortie de ladite pompe (6) est raccordé audit dissipateur de chaleur (3'), et **en ce que** ladite dérivation (9') est raccordée à partir du côté sortie dudit dissipateur de chaleur jusqu'au côté entrée de la pompe.

14. Système de refroidissement selon l'une quelconque des revendications précédentes, **caractérisé en ce que** ledit tube d'admission (19) comporte au moins un trou (23) à travers une paroi de celui-ci près du fond du vase d'expansion (10, 10') et sur l'intérieur du vase d'expansion.

15. Système de refroidissement selon l'une quelconque des revendications précédentes, **caractérisé en ce qu'**il comprend un agencement configuré pour indiquer le niveau de surface de liquide à l'intérieur dudit vase d'expansion (10, 10') et comprenant un tube (29) ayant une extrémité inférieure raccordée au volume interne du vase d'expansion en dessous du plus bas niveau acceptable de liquide de refroidissement et l'autre extrémité raccordée à la partie supérieure du vase d'expansion et ayant un flotteur d'indication (30) indiquant ledit niveau de surface.

16. Système de refroidissement selon la revendication 15, **caractérisé en ce que** ledit agencement comprend un capteur inductif (31) agencé près dudit tube ascendant (29) et ledit flotteur d'indication (30) est fait d'un matériau métallique à détecter par ledit capteur inductif.

17. Système de refroidissement selon la revendication 16, **caractérisé en ce que** ledit capteur inductif (31) est agencé à un niveau qui est un niveau le plus bas acceptable (32) dudit liquide de refroidissement dans le vase d'expansion (10, 10') et pour créer un signal d'avertissement lorsque ce niveau est atteint par une surface du liquide de refroidissement à l'intérieur du vase d'expansion.

18. Véhicule guidé sur rails, **caractérisé en ce qu'**il est doté d'un système de refroidissement selon l'une quelconque des revendications 1 à 17.

19. Utilisation d'un système de refroidissement selon l'une quelconque des revendications 1 à 17 pour des convertisseurs de refroidissement pour la commande du transfert d'énergie électrique dans un véhicule guidé sur rails.
